# FASCICULE DE BREVET EUROPEEN

(11) **EP 3 009 850 B1**
(45) Date de publication et mention de la délivrance du brevet: **04.07.2018**
(21) Numéro de dépôt: 15185366.0
(22) Date de dépôt: 15.09.2015
(51) Int. Cl.: G01R 1/04, G01R 22/06

(54) **EQUIPEMENT DE MESURE COMPORTANT DES MOYENS DE DÉTECTION DE FRAUDE MAGNÉTIQUE**
MESSAUSRÜSTUNG, DIE MITTEL ZUM AUFDECKEN EINES MAGNETISCHEN BETRUGS UMFASST
MEASURING EQUIPMENT COMPRISING MEANS FOR DETECTING MAGNETIC FRAUD

(30) Priorité: 13.10.2014 FR 1459773
(43) Date de publication de la demande: 20.04.2016
(73) Titulaire: SAGEMCOM ENERGY & TELECOM SAS, 92500 Rueil-Malmaison (FR)
(72) Inventeur: BOURGEOIS, Daniel, 92500 Rueil Malmaison (FR); PARIS, Patrick, 92500 Rueil Malmaison (FR)
(74) Mandataire: Lavialle, Bruno François Stéphane

(56) Documents cités:
- WO-A2-2008/065291
- US-A- 5 066 904

## Description

L'invention concerne un équipement de mesure de type compteur électrique comprenant des moyens de détection d'une tentative de fraude magnétique. Les moyens de détection détectant une fraude à partir de la valeur d'un courant circulant dans un composant inductif de l'équipement de mesure.

### ARRIERE PLAN DE L'INVENTION

Les compteurs électriques modernes sont des compteurs électroniques qui sont bien sûr adaptés à mesurer une quantité d'énergie électrique consommée dans une habitation ou dans un lieu quelconque et à afficher cette mesure, mais qui sont aussi capables de réaliser un certain nombre de fonctions complémentaires : gestion des tarifs par réception d'ordres, relève et programmation à distance, télé-information client, etc.

Les compteurs électroniques comportent au moins une carte électronique comprenant un certain nombre de composants électroniques. Ces composants électroniques sont, pour certains, destinés à réaliser les fonctions évoquées plus tôt, et pour d'autres, utilisés pour gérer le fonctionnement de la carte électronique : composants d'alimentation, de protection contre des surtensions ou des perturbations électromagnétiques, etc.

Certains abonnés tentent frauduleusement de perturber le fonctionnement de leur compteur électronique en utilisant de puissants aimants de manière à fausser la mesure de l'énergie électrique, à couper de manière intermittente ou continue l'alimentation de la carte électronique, ou à empêcher le compteur électronique de communiquer au fournisseur d'énergie électrique des informations sur la consommation d'énergie. Cette pratique bénéficie du développement de la commercialisation d'aimants de taille relativement réduite capables de générer un champs magnétique très important, tels que les aimants en néodyme. Ces aimants agissent principalement sur des composants inductifs de la carte électronique, par exemple sur des transformateurs utilisés pour la mesure de l'énergie électrique consommée, sur des transformateurs utilisés dans une alimentation de la carte, sur des transformateurs utilisés dans des interfaces de communication (typiquement des interfaces Courants Porteurs en Ligne, ou CPL), sur des inductances diverses, etc. Le champ magnétique généré par l'aimant sature les bobines des composants inductifs dont la valeur inductive s'effondre et dont le comportement électrique s'apparente alors à celui d'un fil (court-circuit).

Il est primordial pour le fournisseur d'énergie électrique que le compteur électronique soit capable de détecter une telle tentative de fraude et de remonter une alarme vers un central de surveillance du fournisseur d'énergie électrique. On munit ainsi classiquement un compteur électrique d'un capteur magnétique, par exemple d'un capteur à effet Hall ou d'une ampoule Reed, qui détecte la présence d'un champ magnétique externe généré à proximité du compteur. Des moyens de traitement du compteur génèrent une alarme lorsque le champ magnétique détecté par le capteur magnétique est supérieur à un seuil prédéterminé.

Cependant, la zone de couverture de détection de fraude du capteur magnétique est relativement limitée. Lorsque l'aimant utilisé pour réaliser la tentative de fraude est positionné à l'extérieur de cette zone de couverture, le champ mesuré par le capteur magnétique est trop faible pour permettre de détecter une fraude de manière fiable.

Pour remédier à ce problème, il est bien sûr envisageable d'ajouter des capteurs magnétiques répartis à l'intérieur du compteur de manière à augmenter et à optimiser la zone de couverture. Cette solution présente un certain nombre de désavantages, et notamment un coût et un encombrement élevés résultant de l'ajout des capteurs additionnels et des composants de mesure associés.

### OBJET DE L'INVENTION

L'invention a pour objet un équipement de mesure, tel qu'un compteur électrique, comprenant des moyens de détection de fraude permettant d'augmenter la zone de couverture de détection de fraude et qui soient peu coûteux et/ou peu encombrants.

### RESUME DE L'INVENTION

En vue de la réalisation de ce but, on propose un équipement de mesure de type compteur électrique comportant un boîtier dans lequel est intégré une carte électronique sur laquelle est montée un composant inductif présentant une valeur d'inductance susceptible d'être modifiée par un champ magnétique externe généré par exemple par un aimant pour réaliser une tentative de fraude. Selon l'invention, l'équipement de mesure comporte des moyens de détection de fraude adaptés à détecter une tentative de fraude lorsqu'un courant électrique circulant dans le composant inductif présente une valeur supérieure à un seuil de courant prédéterminé.

Les moyens de détection utilisent donc un composant inductif déjà présent sur la carte électronique de l'équipement de mesure. En associant à ce composant inductif des composants électroniques simples adaptés à comparer le courant électrique avec un seuil de courant prédéterminé, on peut obtenir des moyens de détection de fraude peu coûteux, peu encombrants. On augmente de plus la zone de détection de fraude en utilisant un composant inductif situé à une certaine distance d'un capteur magnétique préexistant.

L'invention sera mieux comprise à la lumière de la description qui suit de modes de mise en oeuvre particuliers non limitatifs de l'invention.

### BREVE DESCRIPTION DES DESSINS

Il sera fait référence aux dessins annexés, parmi lesquels :
- la figure 1 est une vue en perspective de l'équipement de mesure de l'invention qui est ici un compteur électrique;
- la figure 2 représente une première interface de communication de la carte électronique du compteur comportant des moyens de détection de fraude selon un premier mode de réalisation ;
- la figure 3 représente un schéma électrique des moyens de détection de fraude selon le premier mode de réalisation ;
- la figure 4 est un diagramme représentant un algorithme de confirmation de détection de fraude ;
- La figure 5 représente une deuxième interface de communication de la carte électronique du compteur électrique comportant des moyens de détection de fraude selon un deuxième mode de réalisation.

### DESCRIPTION DETAILLEE DE L'INVENTION

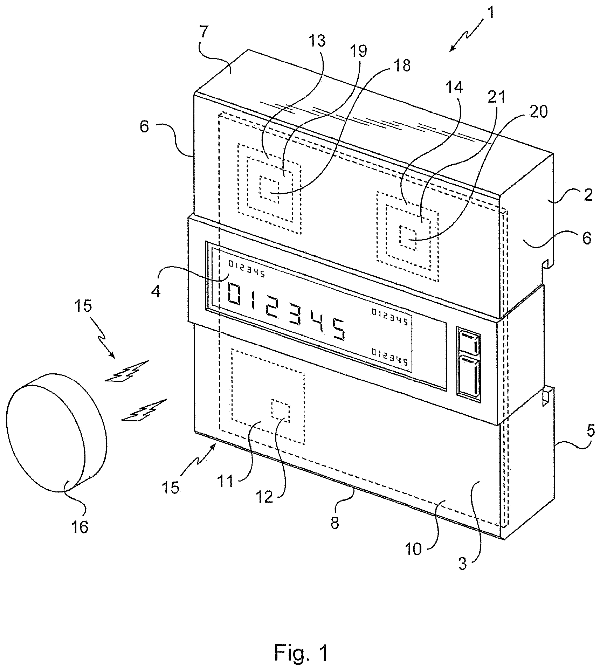

En référence à la figure 1, l'équipement de mesure de l'invention est ici un compteur électrique électronique 1 destiné à mesurer une quantité d'énergie électrique consommée dans une habitation et à afficher cette mesure. Un tel compteur pourrait aussi être connecté à un poste de transformation, à une ligne de transport haute tension, etc. Le compteur électrique 1 est aussi adapté à réaliser un certain nombre de fonctions complémentaires : gestion des tarifs par réception d'ordres, relève et programmation à distance, télé-information client, etc.

Le compteur électrique 1 comporte un boîtier 2 de forme sensiblement parallélépipédique comprenant une face avant 3 munie d'un affichage LCD 4 permettant d'afficher les mesures de la quantité d'énergie électrique consommée par l'habitation, une face arrière 5 munie de moyens de fixation destinés à fixer le boîtier 2 à un mur de l'habitation, deux faces latérales 6, une face supérieure 7 et une face inférieure 8.

Le boîtier 2 contient une carte électronique 10 comportant des moyens de traitement 11 comprenant un microcontrôleur 12, une première interface de communication 13 et une deuxième interface de communication 14.

La carte électronique 10 comporte un certain nombre de composants électroniques, et notamment des composants inductifs qui présentent une valeur inductive susceptible d'être modifiée par un champ magnétique externe 15 généré par exemple par un aimant 16 lors d'une tentative de fraude.

Ces composants inductifs comprennent notamment une première bobine 18 d'un premier transformateur 19 situé dans la première interface de communication 13 et une deuxième bobine 20 d'un deuxième transformateur 21 situé dans la deuxième interface de communication 14.

Le compteur électrique 1 comporte de plus des moyens de détection de fraude adaptés à détecter une tentative de fraude lorsqu'un courant électrique circulant dans l'un de ces composants inductifs présente une valeur supérieure à un seuil de courant prédéterminé.

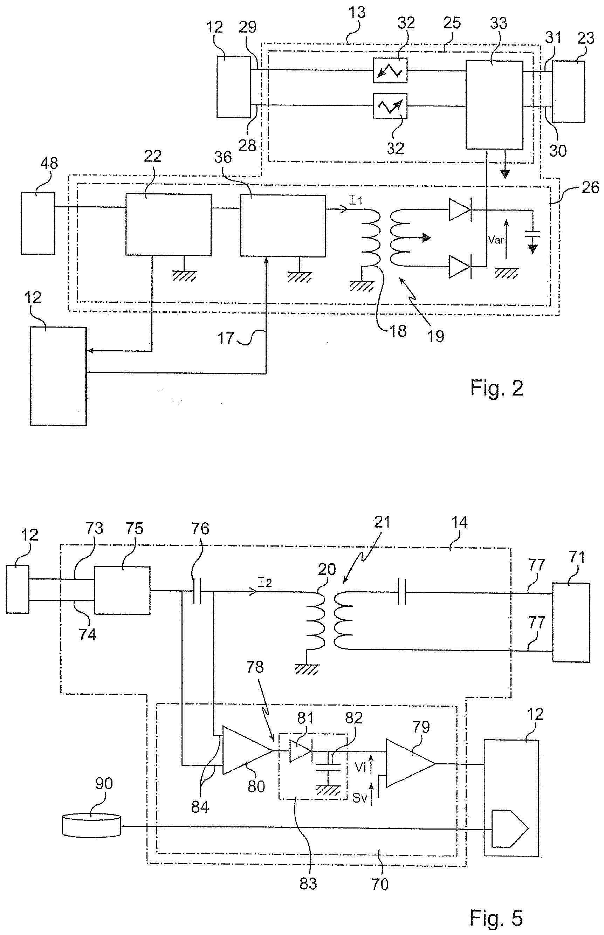

Dans un premier mode de réalisation, que l'on décrit en référence aux figures 2 à 4, les moyens de détection de fraude 22 sont adaptés à détecter une tentative de fraude lorsqu'un premier courant électrique I1 circulant dans la première bobine 18 du premier transformateur 19 présente une valeur supérieure à un premier seuil de courant prédéterminé S1.

La première interface de communication 13 est une interface, ici de type RS232, permettant au compteur électrique 1 de dialoguer avec un premier équipement externe 23 par transmission série. La première interface de communication 13 comporte un circuit de communication 25 par lequel cheminent des données échangées entre le compteur électrique 1 et le premier équipement externe 23, et une alimentation à découpage 26.

Le circuit de communication 25 comprend une première sortie 28, une première entrée 29, une deuxième sortie 30, une deuxième entrée 31, deux optocoupleurs 32 et un composant d'interface 33.

La première sortie 28 et la première entrée 29 permettent au circuit de communication 25 d'échanger des données avec le microcontrôleur 12 des moyens de traitement 11 de la carte électronique 10. La deuxième sortie 30 et la deuxième entrée 31 permettent au circuit de communication 25 d'échanger des données avec le premier équipement externe 23. Les optocoupleurs 32 sont utilisés pour isoler galvaniquement la première interface de communication 13 du reste de la carte électronique 10. Le composant d'interface 33 adapte le format électrique des données émises et reçues pour permettre la communication entre le microcontrôleur 12 et le premier équipement externe 23.

L'alimentation à découpage 26 de la première interface de communication 13 est utilisée pour alimenter le composant d'interface 33 du circuit de communication 25.

L'alimentation à découpage 26 comprend les moyens de détection selon le premier mode de réalisation 22, un circuit de découpage 36 qui fournit une tension d'alimentation régulée Var au composant d'interface 33, et le premier transformateur 19 qui comporte la première bobine 18 et qui permet d'isoler galvaniquement le circuit de communication 25 et l'alimentation à découpage 26. Le circuit de découpage est activé ou désactivé par le microcontrôleur 12 via une liaison 17 de type RS232.

Les moyens de détection 22 sont reliés à un module d'alimentation externe 48 et au microcontrôleur 12 des moyens de traitement 11 de la carte électronique 10.

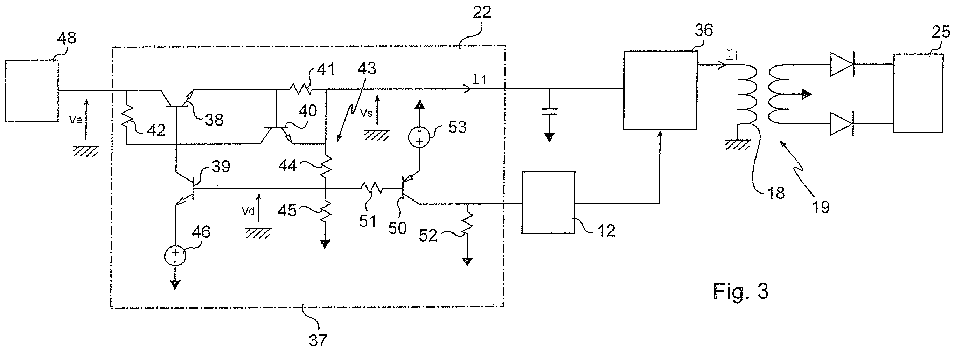

Les moyens de détection 22, mieux visibles sur la figure 3, comprennent des moyens de limitation 37 qui comportent un premier transistor bipolaire NPN 38, un deuxième transistor bipolaire NPN 39, un troisième transistor bipolaire NPN 40, une première résistance 41 utilisée comme résistance de réglage, une deuxième résistance 42 utilisée comme résistance de polarisation, un pont diviseur de tension 43 formé par une troisième résistance 44 et par une quatrième résistance 45, et une première tension de référence 46.

Le premier transistor 38 est monté en série entre le module d'alimentation externe 48 et le circuit de découpage 36, de sorte que le collecteur du premier transistor 38 est relié au module d'alimentation externe 48. L'émetteur du premier transistor 38 est relié à la première résistance 41. La deuxième résistance 42 est connectée entre le module d'alimentation externe 48 et la base du premier transistor 38.

La base du deuxième transistor 39 est connectée au pont diviseur de tension 43 entre la troisième résistance 44 et la quatrième résistance 45. Le collecteur du deuxième transistor 39 est relié à la base du premier transistor 38. L'émetteur du deuxième transistor 39 est relié à la première tension de référence 46.

La base du troisième transistor 40 est reliée à l'émetteur du premier transistor 38, le collecteur du troisième transistor 40 est relié à la base du premier transistor 38 et à la deuxième résistance 42, et l'émetteur du troisième transistor 38 est relié au circuit de découpage 36 à travers la première résistance 41.

Le pont diviseur de tension 43 est connecté en sortie des moyens de limitation 37. La première résistance 41 est quant à elle connectée entre la base du troisième transistor 40 et le circuit de découpage 36.

Les moyens de limitation 37 sont adaptés à réguler une tension de sortie Vs générée à la sortie des moyens de limitation 37 à partir d'une tension d'entrée Ve fournie aux moyens de limitation 37 par le module d'alimentation externe 48. La tension de sortie Vs est fournie au circuit de découpage 36 qui est alimenté par le premier courant électrique I1 sous la tension de sortie Vs.

La tension de sortie Vs est régulée pour atteindre une valeur nominale.

Le pont diviseur de tension 43 est destiné à diviser la tension de sortie Vs et à générer une tension divisée Vd. Le deuxième transistor 39 compare la tension divisée Vd avec la première tension de référence 46. Lorsque la tension de sortie Vs dépasse une tension de sortie maximale, la différence entre la tension divisée Vd et la première tension de référence 46 s'accroît et le deuxième transistor 39 tire du courant dans la deuxième résistance 42. Le courant dans la base du premier transistor 38 diminue alors, et la tension de sortie Vs diminue.

Les moyens de limitation 37 sont aussi adaptés à limiter le premier courant électrique I1 lorsque la valeur du premier courant électrique I1 dépasse le seuil prédéterminé S1.

Lorsque le premier courant électrique I1 dépasse le seuil prédéterminé S1, le troisième transistor 40 tire du courant dans la deuxième résistance 42, ce qui réduit fortement le premier courant électrique I1.

Le seuil prédéterminé est réglé grâce à la première résistance 41.

Enfin, pour détecter que le premier courant I1 a dépassé le seuil prédéterminé S1, les moyens de détection 22 comportent un quatrième transistor bipolaire PNP 50, une cinquième résistance 51, une sixième résistance 52 et une deuxième tension de référence 53.

Le quatrième transistor 50 compare la tension divisée Vd à la deuxième tension de référence 53. Lorsque le premier courant électrique I1 est réduit fortement après avoir dépassé le seuil prédéterminé S1, la tension divisée Vd s'écroule et devient inférieure à la deuxième tension de référence 53. Le quatrième transistor 50 devient alors passant et la deuxième tension de référence 53 est appliquée en entrée du microcontrôleur 12 des moyens de traitement 11, qui génère une alarme indiquant qu'une tentative de fraude vient d'être réalisée.

On note que le premier seuil prédéterminé S1 est défini pour être nettement supérieur au courant maximal consommé par le composant d'interface 33 du circuit de communication 25, de sorte qu'un dépassement par le premier courant électrique I1 du premier seuil prédéterminé S1 révèle à coup sûr une tentative de fraude.

On note aussi que les moyens de détection 22 permettent non seulement de révéler la tentative de fraude, mais aussi d'indiquer que la première interface de communication est défaillante.

On fournit à titre d'exemple des valeurs numériques des composants utilisés.

La première résistance 41 a une valeur de 10 ohms, la deuxième résistance 42 a une valeur de 3,3 kiloohms, la troisième résistance 44 a une valeur de 11 kiloohms, la quatrième résistance 45 a une valeur de 33 kiloohms, et la première tension de référence 46 a une valeur de 3,3 volts. La valeur nominale de la tension de sortie Vs est de 5 volts et la valeur maximale de la tension de sortie Vs est de 5,2 volts. La valeur du premier seuil prédéterminé S1 est de 60 milliampères, pour une consommation maximale de 30 milliampères du composant d'interface 33 du circuit de communication 25. La cinquième résistance a une valeur de 100 kiloohms, la sixième résistance a une valeur de 100 kiloohms, et la deuxième tension de référence 53 a une valeur de 3,3 Volts.

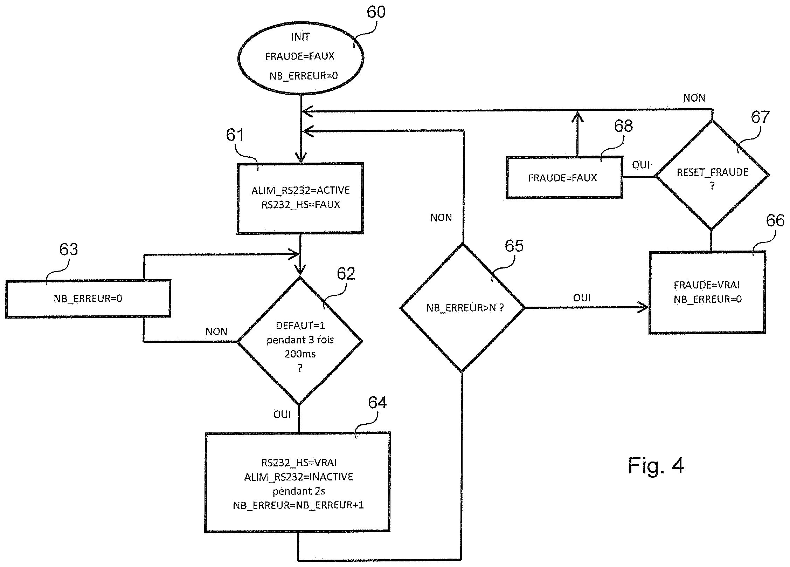

En référence à la figure 4, on décrit maintenant le fonctionnement d'un algorithme programmé dans le microcontrôleur 12 et destiné à confirmer une tentative de fraude.

Cet algorithme utilise les variables suivantes : ALIM_RS232, DEFAUT, NB_ERREUR, RS232_HS, FRAUDE, RESET_FRAUDE.

Lorsque la variable ALIM_RS232 prend la valeur DESACTIVE, l'alimentation de la première interface de communication 13 est désactivée.

La variable DEFAUT prend la valeur 1 lorsque le premier courant électrique I1 présente une valeur supérieure au premier seuil de courant prédéterminé S1.

La variable NB_ERROR confirme la variable DEFAUT.

La variable RS232_HS indique que la première interface de communication 13 est considérée comme non fonctionnelle, potentiellement à cause d'une tentative de fraude.

La variable FRAUDE indique qu'une tentative fraude est effectivement détectée.

La variable RESET_FRAUDE indique que la tentative de fraude effectivement détectée est terminée.

L'algorithme comporte une première étape 60, dans laquelle la variable FRAUDE est mise à FAUX, et la variable NB_ERROR à 0.

L'algorithme comporte une deuxième étape 61 au cours de laquelle l'alimentation de la première interface de communication 13 est activée et au cours de laquelle on considère que la première interface de communication 13 est fonctionnelle. La variable ALIM_RS232 prend la valeur ACTIVE et la variable RS232_HS prend la valeur FAUX.

L'algorithme comporte une troisième étape 62 au cours de laquelle on vérifie si la variable DEFAUT est à 1 pendant trois fois 200 millisecondes. Ce temps de confirmation, dont la durée est fournie à titre d'exemple, permet d'éviter la détection d'un défaut transitoire.

Si ce n'est pas le cas, la variable NB_ERREUR prend la valeur 0 au cours d'une quatrième étape 63.

Si c'est le cas, une cinquième étape 64 est mise en oeuvre, au cours de laquelle la valeur de NB_ERREUR est incrémentée d'une unité, la variable RS232_HS prend la valeur VRAI, et la variable ALIM_RS232 prend la valeur DESACTIVE pendant deux secondes. L'alimentation de la première interface de communication 13 est donc désactivée pendant deux secondes, dans le but de réinitialiser la première interface de communication 13.

L'algorithme comporte ensuite une sixième étape 65 qui a pour effet de relancer l'algorithme au niveau de la deuxième étape 61 si la valeur de NB_ERREUR est inférieure ou égale à une constante N, c'est-à-dire tant que l'alimentation de la première interface de communication 13 n'a pas été désactivée N fois de suite pendant 2 secondes pour tenter, à chaque fois, de corriger un défaut confirmé pendant trois fois 200 millisecondes.

Lorsque la variable NB_ERREUR devient supérieure à la constante N, une septième étape 66 est réalisée, au cours de laquelle la variable FRAUDE prend la valeur VRAIE et la variable NB_ERREUR prend la valeur 0.

Puis, une huitième étape 67 est réalisée au cours de laquelle on vérifie si la tentative de fraude est terminée. La vérification est effectuée par l'intervention d'un opérateur autorisé, localement ou à distance (via un PC). Si c'est le cas, c'est-à-dire si la variable RESET_FRAUDE a pris la valeur FAUX, une neuvième étape 68 est réalisée au cours de laquelle la variable FRAUDE est portée à la valeur FAUX et l'algorithme reprend à partir de la deuxième étape 61. Si ce n'est pas le cas, l'algorithme reprend à partir de la deuxième étape 61.

Dans un deuxième mode de réalisation, que l'on décrit en référence à la figure 5, les moyens de détection de fraude 70 sont adaptés à détecter une tentative de fraude lorsqu'un deuxième courant électrique I2 circulant dans la deuxième bobine 20 du deuxième transformateur 21 présente une valeur supérieure à un deuxième seuil de courant prédéterminé S2.

La deuxième interface de communication 14 est une interface de type Télé-Information Client permettant au compteur électrique 1 de dialoguer avec un deuxième équipement externe 71.

La deuxième interface de communication 14 comporte une entrée de données 73, une entrée d'horloge 74, un émetteur-récepteur asynchrone 75, une première capacité 76, le deuxième transformateur 21 comprenant la deuxième bobine 20, deux sorties de données 77, et les moyens de détection selon le deuxième mode de réalisation 70.

L'émetteur-récepteur asynchrone 75 est connecté au microcontrôleur 12 des moyens de traitement 11 de la carte électronique 10. L'émetteur-récepteur asynchrone 75 adapte le format électrique des données reçues et transmises pour permettre la communication entre le microcontrôleur 12 et le deuxième équipement externe 71. Le deuxième transformateur 19 permet d'isoler galvaniquement la carte électronique 10 et les deux sorties de données 77.

Les moyens de détection de fraude 70 selon le deuxième mode de réalisation comportent des moyens de transformation 78 et un comparateur 79.

Les moyens de transformation 78 comprennent un amplificateur différentiel 80, une diode 81 et une deuxième capacité 82 formant un détecteur d'enveloppe 83.

L'amplificateur différentiel 80 possède deux entrées 84 en haute impédance connectées chacune à une borne de la première capacité 76.

Le comparateur 79 est relié au microcontrôleur 12 des moyens de traitement 11 de la carte électronique 10.

L'amplificateur différentiel 80 et le détecteur d'enveloppe 83 transforment le deuxième courant électrique I2 en une tension image Vi représentative de l'amplitude maximale du deuxième courant électrique I2. La tension image Vi est ensuite comparée avec un seuil de tension prédéterminé Sv image d'un deuxième seuil de courant prédéterminé S2.

Lorsque la tension image Vi est supérieure au seuil de tension prédéterminé Sv, indiquant ainsi que la valeur du deuxième courant électrique I2 est supérieure au deuxième seuil de courant prédéterminé S2, le comparateur 79 transmet un état haut au microcontrôleur 12 qui détecte ainsi qu'une tentative de fraude est réalisée.

Avantageusement, un capteur magnétique à effet Hall 90 est relié lui aussi au microcontrôleur 12 des moyens de traitement 11. Le capteur à effet Hall 90 mesure le champ magnétique externe 15 et confirme ou infirme l'alarme générée par les moyens de détection selon le deuxième mode de réalisation 70.

L'invention n'est pas limitée aux modes de mise en oeuvre particuliers qui viennent d'être décrits, mais, bien au contraire, couvre toute variante entrant dans le cadre de l'invention telle que définie par les revendications.

Bien que l'on ait décrit ici l'invention en application à un compteur électrique, celle-ci est applicable à tout type d'équipement de mesure, et en particulier aux équipements liés à un paiement et utilisés pour facturer des services ou des biens facturables.

Bien que l'on ait décrit une architecture électrique particulière du compteur électrique, l'invention est bien sûr applicable à un compteur présentant une architecture électrique différente. Le compteur peut ainsi ne comporter qu'une seule interface de communication, cette interface de communication peut se trouver sur une carte électronique différente de la carte accueillant les moyens de traitement, etc.

Bien que l'on ait indiqué que les courants électriques permettant de détecter la tentative de fraude sont des courants circulant dans des bobines de transformateurs d'interfaces de communication, il est possible d'utiliser les courants circulant dans un autre composant inductif du compteur.

## Revendications

1. Equipement de mesure de type compteur électrique comportant un boîtier (2) dans lequel est intégré une carte électronique (10) sur laquelle est montée un composant inductif (18 ; 20) présentant une valeur d'inductance susceptible d'être modifiée par un champ magnétique externe (15) généré par exemple par un aimant (16) pour réaliser une tentative de fraude, et des moyens de détection de fraude (22 ; 70) **caractérisé en ce que** les moyens de détection de fraude sont adaptés à détecter une tentative de fraude lorsqu'un courant électrique (I1 ; I2) circulant dans le composant inductif présente une valeur supérieure à un seuil de courant prédéterminé (S1 ; S2).

2. Equipement de mesure selon la revendication 1, dans lequel le composant inductif est une bobine (18) d'un transformateur (19) d'une alimentation à découpage (26) de l'équipement de mesure.

3. Equipement de mesure selon la revendication 1, dans lequel le composant inductif est une bobine (18 ; 20) d'un transformateur (19 ; 21) d'une interface de communication (13 ; 14) de l'équipement de mesure.

4. Equipement de mesure selon l'une des revendications précédentes, dans lequel les moyens de détection comportent des moyens de limitation (37) adaptés à limiter le courant électrique lorsque la valeur du courant électrique dépasse le seuil prédéterminé.

5. Equipement de mesure selon la revendication 4, dans lequel les moyens de limitation sont en outre adaptés à réguler une tension de sortie (Vs) générée à partir d'une tension d'entrée (Ve) fournie aux moyens de limitation (37) par un module d'alimentation (48), ladite tension de sortie étant fournie à un circuit (36) alimenté par le courant électrique sous la tension de sortie.

6. Equipement de mesure selon la revendication 5, dans lequel les moyens de limitation comprennent :
- un premier transistor (38) monté en série entre le module d'alimentation et le circuit et destiné à régler le courant électrique ;
- un pont diviseur de tension (43) destiné à diviser la tension de sortie et à générer une tension divisée (Vd) ;
- un deuxième transistor (39) dont une base est reliée au pont diviseur de tension, un collecteur à une base du premier transistor, et un émetteur à une première tension de référence (46), le deuxième transistor étant destiné à comparer la tension divisée avec la première tension de référence et à réduire un courant de base du premier transistor et donc le courant électrique lorsque la tension divisée est supérieure à la première tension de référence.

7. Equipement de mesure selon la revendication 6, dans lequel les moyens de limitation (37) comportent un troisième transistor (40) destiné à réduire le courant de base du premier transistor et donc le courant électrique lorsque la valeur du courant électrique dépasse le seuil prédéterminé.

8. Equipement de mesure selon la revendication 7, dans lequel les moyens de détection comportent un quatrième transistor (50) destiné à comparer la tension divisée avec une deuxième tension de référence (53) et à détecter une tentative de fraude lorsque la tension divisée est inférieure à la deuxième tension de référence.

9. Equipement de mesure selon la revendication 1, dans lequel les moyens de détection comportent des moyens de transformation (80, 83) destinés à générer à partir du courant électrique une tension image du courant électrique, et un comparateur (79) destiné à comparer la tension image avec un seuil de tension prédéterminé image du seuil de courant prédéterminé et à détecter une tentative de fraude lorsque la tension image est supérieure au seuil prédéterminé.

## Patentansprüche

1. Messgerät vom Typ elektrischer Zähler, umfassend ein Gehäuse (2), in dem eine Leiterplatte (10) integriert ist, auf der ein induktives Bauteil (18; 20) montiert ist, das einen Induktivitätswert aufweist, der durch ein äußeres Magnetfeld (15), das beispielsweise durch einen Magneten (16) erzeugt wird, verändert werden kann, um einen Betrugsversuch auszuführen, sowie Betrugserfassungsmittel (22; 70), **dadurch gekennzeichnet, dass** die Betrugserfassungsmittel dazu geeignet sind, einen Betrugsversuch zu erfassen, wenn ein elektrischer Strom (I1; I2), der in dem induktiven Bauteil fließt, einen Wert aufweist, der größer als ein vorgegebener Stromschwellwert (S1; S2) ist.

2. Messgerät nach Anspruch 1, bei dem das induktive Bauteil eine Spule (18) eines Transformators (1) eines Schaltnetzteils (26) des Messgeräts ist.

3. Messgerät nach Anspruch 1, bei dem das induktive Bauteil eine Spule (18; 20) eines Transformators (19; 21) einer Kommunikationsschnittstelle (13; 14) des Messgeräts ist.

4. Messgerät nach einem der vorhergehenden Ansprüche, bei dem die Erfassungsmittel Begrenzungsmittel (37) umfassen, die dazu geeignet sind, den elektrischen Strom zu begrenzen, wenn der Wert des elektrischen Stroms den vorgegebenen Schwellwert überschreitet.

5. Messgerät nach Anspruch 4, bei dem die Begrenzungsmittel ferner dazu geeignet sind, eine Ausgangsspannung (Vs), die aus einer Eingangsspannung (Ve) erzeugt wird, die den Begrenzungsmitteln (37) von einem Versorgungsmodul (48) zugeführt wird, zu regulieren, wobei die genannte Ausgangspannung einem Schaltkreis (36) zugeführt wird, der von dem elektrischen Strom unter Ausgangsspannung gespeist wird.

6. Messgerät nach Anspruch 5, bei dem die Begrenzungsmittel umfassen:
- einen ersten Transistor (38), der zwischen dem Versorgungsmodul und dem Schaltkreis in Reihe geschaltet und dazu bestimmt ist, den elektrischen Strom zu regeln;
- eine Spannungsteilerbrücke (43), die dazu bestimmt ist, die Ausgangsspannung zu teilen und eine geteilte Spannung (Vd) zu erzeugen;
- einen zweiten Transistor (39), von dem eine Basis mit der Spannungsteilerbrücke, ein Kollektor mit einer Basis des ersten Transistors und ein Emitter mit einer ersten Referenzspannung (46) verbunden ist, wobei der zweite Transistor dazu bestimmt ist, die geteilte Spannung mit der ersten Referenzspannung zu vergleichen und einen Basisstrom des ersten Transistors und folglich den elektrischen Strom zu reduzieren, wenn die geteilte Spannung größer als die erste Referenzspannung ist.

7. Messgerät nach Anspruch 6, bei der die Begrenzungsmittel (37) einen dritten Transistor (40) umfassen, der dazu bestimmt ist, den Basisstrom des ersten Transistors und folglich den elektrischen Strom zu reduzieren, wenn der Wert des elektrischen Stroms den vorgegebenen Schwellwert überschreitet.

8. Messgerät nach Anspruch 7, bei dem die Erfassungsmittel einen vierten Transistor (50) umfassen, der dazu bestimmt ist, die geteilte Spannung mit einer zweiten Referenzspannung (53) zu vergleichen und einen Betrugsversuch zu erfassen, wenn die geteilte Spannung kleiner als die zweite Referenzspannung ist.

9. Messgerät nach Anspruch 1, bei dem die Erfassungsmittel Transformationsmittel (80, 83) umfassen, die dazu bestimmt sind, aus dem elektrischen Strom eine Bildspannung des elektrischen Stroms zu erzeugen, sowie einen Komparator (79), der dazu bestimmt ist, die Bildspannung mit einem vorgegebenen Bildspannungsschwellwert des vorgegebenen Stromschwellwertes zu vergleichen und einen Betrugsversuch zu erfassen, wenn die Bildspannung größer als der vorgegebene Schwellwert ist.

## Claims

1. Measurement equipment of the electricity meter type, the equipment comprising a case (2) incorporating an electronic card (10) having mounted thereon an inductive component (18; 20) presenting both an inductance value suitable for being modified by an external magnetic field (15), e.g. generated by a magnet (16) in order to attempt a fraud, and also fraud detection means (22; 70), the equipment being **characterized in that** the fraud detection means are adapted to detect an attempt at fraud when an electric current (I1; I2) flowing in the inductive component presents a value greater than a predetermined current threshold (S1; S2).

2. Measurement equipment according to claim 1, wherein the inductive component is a coil (18) of a transformer (19) of a switch mode power supply (26) of the measurement equipment.

3. Measurement equipment according to claim 1, wherein the inductive component is a coil (18; 20) of a transformer (19; 21) of a communications interface (13; 14) of the measurement equipment.

4. Measurement equipment according to any preceding claim, wherein the detection means include limiter means (37) adapted to limit the electric current when the value of the electric current exceeds the predetermined threshold.

5. Measurement equipment according to claim 4, wherein the limiter means are also adapted to regulate an output voltage (Vs) generated from an input voltage (Ve) delivered to the limiter means (37) by a power supply module (48), said output voltage being delivered to a circuit (36) powered by the electric current at the output voltage.

6. Measurement equipment according to claim 5, wherein the limiter means comprise:
- a first transistor (38) connected in series between the power supply module and the circuit for the purpose of regulating the electric current;
- a voltage divider bridge (43) for dividing the output voltage and generating a divided voltage (Vd); and
- a second transistor (39) having a base connected to the voltage divider bridge, a collector connected to a base of the first transistor, and an emitter connected to a first reference voltage (46), the second transistor being for comparing the divided voltage with the reference voltage and for reducing the base current of the first transistor and thus the electric current when the divided voltage is greater than the first reference voltage.

7. Measurement equipment according to claim 6, wherein the limiter means (37) include a third transistor (40) for reducing the base current of the first transistor and thus the electric current when the value of the electric current exceeds the predetermined threshold.

8. Measurement equipment according to claim 7, wherein the detector means include a fourth transistor (50) for comparing the divided voltage with a second reference voltage (53) and for detecting an attempt at fraud when the divided voltage is less than the second reference voltage.

9. Measurement equipment according to claim 1, wherein the detector means include transformation means (80, 83) for generating an image voltage on the basis of the electric current, which voltage is an image of the electric current, and a comparator (79) for comparing the image voltage with a predetermined voltage threshold that is the image of the predetermined current threshold and for detecting an attempt at fraud when the image voltage is greater than the predetermined threshold.
